# EUROPÄISCHE PATENTSCHRIFT

(11) **EP 1 341 325 B1**
(45) Veröffentlichungstag und Bekanntmachung des Hinweises auf die Patenterteilung: **10.01.2007**
(21) Anmeldenummer: 02004777.5
(22) Anmeldetag: 01.03.2002
(51) Int. Cl.: H04B 17/00, G01R 31/28

(54) **Schaltungsanordnung zum Testen von Funktionen einer Hochfrequenzschaltung**
Circuit arrangement for testing functions of a high-frequency circuit
Dispositif pour contrôler des fonctions d'un circuit à haute fréquence

(43) Veröffentlichungstag der Anmeldung: 03.09.2003
(73) Patentinhaber: BenQ Mobile GmbH & Co. OHG, 81667 München (DE)
(72) Erfinder: Matuszczak, Dirk, 46519 Alpen (DE)

(56) Entgegenhaltungen:
- EP-A- 0 709 686
- US-A- 5 577 269

## Beschreibung

Die Erfindung bezieht sich auf eine Schaltungsanordnung zum Testen von Funktionen einer Hochfrequenzschaltung, mit einem Testpunkt für ein Prüfelement, an dem ein zu testendes Signal der Hochfrequenzschaltung abgegriffen wird, und einem Kurzschlusspunkt für ein Kurzschlusselement, mit dem eine zusätzliche Schaltungskomponente, die mit der Hochfrequenzschaltung über ein Lambda/4-Leitungsstück verbunden ist, kurzgeschlossen wird.

Eine solche Schaltungsanordnung kommt beispielsweise bei Mobiltelefonen zur Abtrennung einer Schaltungskomponente, wie einer integrierten Antenne, über ein Lambda/4-Leitungsstück zum Einsatz, wobei bei einem Testpunkt eine prüftechnische Begutachtung einer Hochfrequenzschaltung in der Produktion vorzunehmen ist.

Im Rahmen der prüftechnischen Begutachtung des Mobiltelefons wird in der Fertigung die Hochfrequenzschaltung mit einer Prüfnadel getestet. Solche Hochfrequenzmessungen beziehen sich auf eine charakteristische Impedanz Z₀, die in den meisten Fällen 50 Ohm beträgt. Wird von dieser Impedanz abgewichen, so werden die mit der Prüfnadel an dem Testpunkt gewonnenen Messergebnisse verfälscht und eine zufriedenstellende Prüfung der Hochfrequenzschaltung ist nicht möglich.

Fehlerhafte Messergebnisse ergeben sich beispielsweise dann, wenn die Prüfnadel den gewählten Testpunkt kontaktiert und somit die restliche Schaltungsanordnung, die bereits für den Normalbetrieb des Mobiltelefons auf die Impedanz Z₀ ausgelegt ist, durch die dadurch entstehende Parallelschaltung beeinflusst.

Aufgrund dessen ist üblicher Weise in dem Mobiltelefon die eingangs genannte Schaltungsanordnung integriert, mit der solche Fehlmessungen vermieden werden, die jedoch in dem Normalbetrieb des Mobiltelefons nicht aktiv sein soll.

Bisher wurde die erforderliche Schaltungsanordnung zum Testen von Funktionen der Hochfrequenzschaltung wie folgt verwirklicht: Zur Durchführung von Testmessungen der zu prüfenden Hochfrequenzschaltung in der Produktion wurde ein zusätzlicher Kurzschlusspunkt auf einer Leiterplatte des Mobiltelefons, welche die zu testende Hochfrequenzschaltung, die zusätzliche Schaltungskomponente und die Schaltungsanordnung zum Testen von Funktionen der Hochfrequenzschaltung trägt, eingesetzt, wobei der zusätzliche Kurzschlusspunkt in einer Fertigungslinie durch eine zusätzliche Prüfnadel kurzgeschlossen wurde. Nach dem Stand der Technik benötigt somit die Schaltungsanordnung zum Testen von Funktionen einer Hochfrequenzschaltung sowohl für den Testpunkt als auch für den Kurzschlusspunkt jeweils eine gesonderte Prüfnadel.

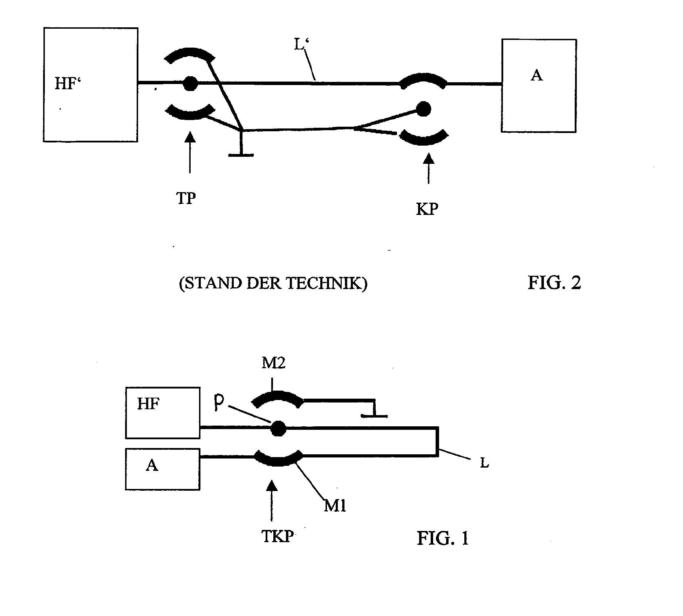

Die soeben erläuterte Schaltungsanordnung nach dem Stand der Technik ist in der Figur 2 veranschaulicht.

Es ist ein Testpunkt TP vorgesehen, der zum Eingriff mit einer Test-Prüfnadel TP ausgebildet ist. Im einzelnen weist der Testpunkt zwei gegenüberliegend angeordnete, kreissegmentförmige Massekontakte sowie einen zwischen den Massenkontakten angeordneten, punktförmigen Prüfkontakt auf, der auf seiner einen Seite mit einer zu testenden Hochfrequenzschaltung HF` und auf seiner anderen Seite mit einem Lambda/4-Leitungsstück L` verbunden ist. An dem dem Testpunkt TP abgewandten Ende des Lambda/4-Leitungsstücks L` ist ein Kurzschlusspunkt KP vorgesehen, der ebenfalls zwei kreissegmentförmige Massekontakte und einen auch an Masse anliegenden punktförmigen weiteren Kontakt aufweist. Eine Antenne A` als abzutrennende, zusätzliche Schaltungskomponente ist beim Einsetzen einer Prüfnadel an dem Kurzschlusspunkt KP kurzgeschlossen, denn sie ist an einen der Massekontakte des Kurzschlusspunktes angeschlossen.

Sobald auf den Kurzschlusspunkt KP eine Prüfnadel gesetzt wird, die dort einen Kurzschluss erzeugt, wird der Kurzschluss über das Lambda/4-Leitungsstück in einen Leerlauf an dem Testpunkt TP transformiert. An dem Testpunkt TP kontaktiert gleichzeitig eine Prüfnadel, mit der eine Testmessung für die Hochfrequenzschaltung ohne Einfluss der vorhandenen Antenne A` möglich ist.

Des weiteren ist im Stand der Technik zum Ermöglichen einer fehlerfreien Durchführung von Testmessungen für Hochfrequenzschaltungen eine Vorgehensweise bekannt, bei der ein zusätzlicher Hochfrequenzschalter auf die Leiterplatte gesetzt wird, mit dem die abzutrennende, zusätzliche Schaltungskomponente während der Fertigungsmessungen deaktiviert wird.

Zusätzlich ist aus der EP 0 709 686 A2 eine Schaltungsanordnung bekannt, bei der der Testpunkt und der Kurzschlusspunkt im Wesentlichen räumlich zusammenfallen. Die räumliche Nähe wird jedoch durch eine sehr komplexe Anordnung erreicht. So besteht das Printed Circuit Board (PCB) aus mehreren leitenden Schichten, die durch Isolationsschichten voneinander getrennt werden. Ebenso weist das verwendete Prüfelement einen komplexen Aufbau auf. Deswegen ist die Herstellung des PCB und des Prüfelements aufwändig und damit teuer. Aufgrund des komplexen Aufbaus des Prüfelements ist dieses leicht zu beschädigen. Zudem weist das Prüfelement beim Prüfen bezüglich seiner Rotationsachse nur eine Position auf, in der es in den Testpunkt und den Kurzschlusspunkt eingeführt werden kann. Dadurch ist der Prüfprozess aufwändig.

Ausgehend hiervon liegt der Erfindung die Aufgabe zugrunde, eine Schaltungsanordnung zum Testen von Funktionen einer Hochfrequenzschaltung zu schaffen, die gegenüber bisherigen Schaltungsanordnungen vereinfacht ist.

Diese Aufgabe wird durch eine Schaltungsanordnung gemäß Anspruch 1 gelöst.

Diese Schaltungsanordnung ermöglicht es somit, mit einer einzigen Prüfnadel, deren äußere Form an die relative Anordnung des Signalkontaktes und des Massekontaktes der Schaltungsanordnung angepasst ist, sowohl Testmessungen durchzuführen als auch den erforderlichen Kurzschluss herbeizuführen. Insofern ergibt sich gegenüber dem oben zuerst diskutierten Stand der Technik eine Halbierung der einzusetzenden Prüfnadeln und auch eine Vereinfachung der Schaltungsanordnung an sich. Auf einen zusätzlichen Hochfrequenzschalter, wie er bei einem weiteren, diskutierten Stand der Technik eingesetzt wird, kann vollständig verzichtet werden.

Bevorzugt handelt es sich bei der Hochfrequenzschaltung um eine Bluetooth-, eine GSM-, eine DECT oder eine "wireless LAN"-, Sende-/Empfangseinrichtung. Eigenschaften solcher Hochfrequenzschaltungen können ohne weiteres mit einer einzigen Prüfnadel an dem Test-/Kurzschlusspunkt vorgenommen werden.

Beim Einsatz der Schaltungsanordnung im Mobilfunkbereich wird die zusätzliche Schaltungskomponente in vielen Fällen eine Mobilfunkantenne sein, die zum Testen von Funktionen der Hochfrequenzschaltung abzutrennen ist.

Ein Ausführungsbeispiel der Erfindung wird nachfolgend anhand der Zeichnung, die eine Schaltungsanordnung zum Testen von Funktionen einer Hochfrequenzschaltung zeigt, noch näher erläutert.

Figur 1 zeigt eine Schaltungsanordnung zum Testen von Funktionen einer Hochfrequenzschaltung HF mit einem Test-/Kurzschlusspunkt TKP, an dem sowohl Signale abgegriffen werden, die auf Eigenschaften einer zu testenden Hochfrequenzschaltung zu prüfen sind, als auch ein erforderlicher Kurzschluss für eine zusätzliche Schaltungskomponente, im vorliegenden Ausführungsbeispiel eine Mobilfunkantenne A, verwirklicht wird.

Der Test-/Kurzschlusspunkt TKP weist zwei Massekontakte M1, M2 und einen Prüfkontakt P auf. Die beiden Massekontakte M1, M2 sind kreissegmentförmig und in bezug auf einen Kreismittelpunkt gegenüberliegend angeordnet. Im Mittelpunkt des Kreises ist der punktförmig ausgebildete Prüfkontakt P vorgesehen.

Der Prüfkontakt P ist über ein Lambda/4-Leitungsstück L mit dem Massekontakt M1 verbunden, an dessen verbleibender Seite die Antenne A angeordnet ist.

Der erforderliche Kurzschluss wird über das Lambda/4-Leitungsstück L in einen Leerlauf an dem Prüfkontakt P transformiert, wodurch eine fehlerfreie Testmessung für die Hochfrequenzschaltung HF ohne Einfluss der vorhandenen Antenne A durchführt werden kann.

Durch die Einsparung des im Stand der Technik vorgesehenen, gesonderten Kurzschlusspunktes halbiert sich etwa die benötigte Fläche für die Schaltungsanordnung zum Testen von Funktionen der Hochfrequenzschaltung. Die Einsparung einer Prüfnadel führt auch zu einer Kostenersparnis.

## Patentansprüche

1. Schaltungsanordnung zum Testen von Funktionen einer Hochfrequenzschaltung (HF),
- mit einem Testpunkt (TKP), der einen Prüfkontakt (P) umfasst, an dem ein Prüfelement ein zu testendes Signal der Hochfrequenzschaltung (HF) abgreift, und
- mit einem Kurzschlusspunkt (TKP), der einen ersten Kontakt (M1), der mit einer zusätzlichen Schaltungskomponente (A) und mit der Hochfrequenzschaltung (HF) über ein Lambda/4-Leitungsstück (L) verbunden ist, und einen zweiten Kontakt (M2) umfasst, der mit Masse verbunden ist, wobei ein Kurzschlusselement die zusätzliche Schaltungskomponente (A) kurzschließt, indem das Kurzschlusselement den ersten (M1) und den zweiten Kontakt (M2) miteinander verbindet,
- wobei der Testpunkt (TKP) mit dem Kurzschlusspunkt (TKP) im Wesentlichen räumlich zusammenfällt,
**dadurch gekennzeichnet, dass**
- der erste (M1) und der zweite Kontakt (M2) kreissegmentförmig ausgebildet sind und
- der erste Kontakt (M1) dem zweiten Kontakt (M2) in Bezug auf einen Kreismittelpunkt gegenüberliegend angeordnet ist.

2. Schaltung nach Anspruch 1,
**dadurch gekennzeichnet,**
**dass** es sich bei der Hochfrequenzschaltung (AF) um eine Bluetooth-, eine GSM-, eine DECT oder eine "wireless LAN"-, Sende-/Empfangseinrichtung handelt.

3. Schaltung nach einem der Ansprüche 1 oder 2,
**dadurch gekennzeichnet,**
**dass** die zusätzliche Schaltungskomponente (A) eine Mobilfunkantenne ist.

## Claims

1. Circuit arrangement for testing functions of a radio-frequency circuit (HF),
- having a test point (TKP), which comprises a test contact (P), at which a test element taps off a signal to be tested from the radio-frequency circuit (HF), and
- having a short-circuiting point (TKP), which comprises a first contact (M1), which is connected to an additional circuit component (A) and to the radio-frequency circuit (HF) via a lambda/4 piece of line (L), and a second contact (M2), which is connected to earth, with a short-circuiting element short-circuiting the additional circuit component (A) by the short-circuiting element connecting the first (M1) and the second contact (M2) to one another,
- with the test point (TKP) essentially physically coinciding with the short-circuiting point (TKP),
**characterized in that**
- the first (M1) and the second contact (M2) are in the form of circle segments, and
- the first contact (M1) is arranged opposite the second contact (M2) with respect to the centre of a circle.

2. Circuit according to Claim 1,
**characterized**
**in that** the radio-frequency circuit (AF) is a Bluetooth, a GSM, a DECT or a "wireless LAN" transmitting/receiving device.

3. Circuit according to one of Claims 1 or 2,
**characterized**
**in that** the additional circuit component (A) is a mobile radio antenna.

## Revendications

1. Circuit pour tester des fonctions d'un circuit haute fréquence (HF), avec
- un point de test (TKP) qui comprend un contact de contrôle (P) au niveau duquel un élément de contrôle prélève un signal à tester du circuit haute fréquence (HF) et
- un point de court-circuit (TKP) qui comprend un premier contact (M1) qui est relié à une composante supplémentaire du circuit (A) et au circuit haute fréquence (HF) via un tronçon de ligne lambda/4 (L) et un deuxième contact (M2) qui est relié à la masse, un élément de court-circuit court-circuitant la composante supplémentaire du circuit (A) par le fait que l'élément de court-circuit relie entre eux le premier contact (M1) et le deuxième contact (M2),
- le point de test (TKP) coïncidant sensiblement avec le point de court-circuit (TKP) dans l'espace,
**caractérisé en ce que**
- le premier contact (M1) et le deuxième contact (M2) sont réalisés sous la forme de segments de cercle et
- le premier contact (M1) est situé en face du deuxième contact (M2) par rapport à un point central du cercle.

2. Circuit selon la revendication 1, **caractérisé en ce que** le circuit haute fréquence (HF) est de préférence un équipement émetteur / récepteur Bluetooth, GSM, DECT ou «wireless LAN».

3. Circuit selon l'une des revendications 1 ou 2, **caractérisé en ce que** la composante supplémentaire du circuit (A) est une antenne radio mobile.
